# EUROPÄISCHE PATENTSCHRIFT

(11) **EP 0 831 520 B1**
(45) Veröffentlichungstag und Bekanntmachung des Hinweises auf die Patenterteilung: **29.09.2004**
(21) Anmeldenummer: 97111179.4
(22) Anmeldetag: 03.07.1997
(51) Int. Cl.: H01L 21/28

(54) **Verfahren zur Herstellung einer MIS-Struktur auf Siliziumkarbid (SiC)**
Method of manufacturing a MIS structure on silicon carbide (SiC)
Méthode de fabrication d'une structure MIS en carbure de silicium (SiC)

(30) Priorität: 19.07.1996 DE 19629267
(43) Veröffentlichungstag der Anmeldung: 25.03.1998
(73) Patentinhaber: Infineon Technologies AG, 81669 München (DE)
(72) Erfinder: Schörner, Reinhold, Dr., 91091 Grossenseebach (DE); Friedrichs, Peter, 90419 Nürnberg (DE)
(74) Vertreter: Patentanwälte Westphal, Mussgnug & Partner

(56) Entgegenhaltungen:
- PARK J S ET AL: "RELIABILITY IMPROVEMENT OF THIN OXIDE BY DOUBLE DEPOSITION PROCESS OF SILICON USING CHEMICAL VAPOR DEPOSITION" JAPANESE JOURNAL OF APPLIED PHYSICS, Bd. 33, Nr. 7A, PART 02, 1. Juli 1994, Seite L921/L922 XP000595127
- XIE W ET AL: "The effect of thermal processing on polycrystalline silicon/SiO/sub 2//6H-SiC metal-oxide-semiconductor devices" APPLIED PHYSICS LETTERS, 15 APRIL 1996, AIP, USA, Bd. 68, Nr. 16, Seiten 2231-2233, XP002082317 ISSN 0003-6951
- STEIN VON KAMIENSKI E G ET AL: "Long term stability of gate-oxides on n- and p-type silicon carbide studied by charge injection techniques" E-MRS 96 SPRING MEETING, SYMPOSIUM A: HIGH TEMPERATURE ELECTRONICS: MATERIALS, DEVICES AND APPLICATIONS, STRASBOURG, FRANCE, 4-7 JUNE 1996, Bd. B46, Nr. 1-3, Seiten 263-266, XP004085324 ISSN 0921-5107, Materials Science & Engineering B (Solid-State Materials for Advanced Technology), April 1997, Elsevier, Switzerland

## Beschreibung

### 1. Einleitung

Das Basiselement eines MOS-Feldeffekt-Transistors (MOSFET) ist die aus der sog. Gate-Elektrode, dem Isolator und dem Halbleiter bestehende MOS - Struktur. Ihre die Funktion und Stabilität des MOSFET's grundlegend bestimmenden elektrischen Eigenschaften kann man beispielsweise an entsprechend aufgebauten MOS-Teststrukturen durch Untersuchung des Kapazitäts /Spannungs- und Strom/Spannungs-Verhaltens ermitteln. Bestimmend für die Qualität der MOS-Struktur sind die Dichte ortsfester Ladungen und die Dichte umladbarer Haftstellen an der Grenzfläche Isolator-Halbleiter sowie die Stärke der durch die gesamte Struktur fließenden Leckströme. Während ortsfeste Ladungen die Einsatzspannung eines unipolaren Transistors verschieben, reduzieren Haftstellen die Beweglichkeit der Ladungsträger im Kanal des MOSFET's. Die durch den MOS-Kondensator fließenden Leckströme sollten möglichst klein sein, um eine Aufladung von Haftstellen im Gateoxid und die damit einhergehende Degradierung der Langzeitstabilität sowie der Transistorkenndaten zu verhindern.

Die Gate-Elektrode von MOSFET-Bauelementen wird in der Regel nicht aus einem Metall, sondern aus hochdotiertem Polysilicium gefertigt. Dies wirkt sich insbesondere technologisch vorteilhaft aus, da man bei der Herstellung der MOSFETs selbstjustierende Prozesse einsetzen und nach der Abscheidung des Gatematerials Hochtemperaturverfahren anwenden kann . Zum anderen verbessert Polysilicium diejenigen elektrischen Kenndaten der MOS-Struktur, welche von den Eigenschaften der durch die Gate-Elektrode und den Gate-Isolator gebildeten Grenzfläche abhängen. So kommt es auch bei Belastung der MOS-Struktur mit starken elektrischen Feldern zu keiner wesentlichen Degradation der Langzeitstabilität. Letzteres ist insbesondere für den Einsatz der MOSFETs im Bereich der Leistungs- und Hochtemperaturelektronik von ausschlaggebender Bedeutung.

### 2. Stand der Technik

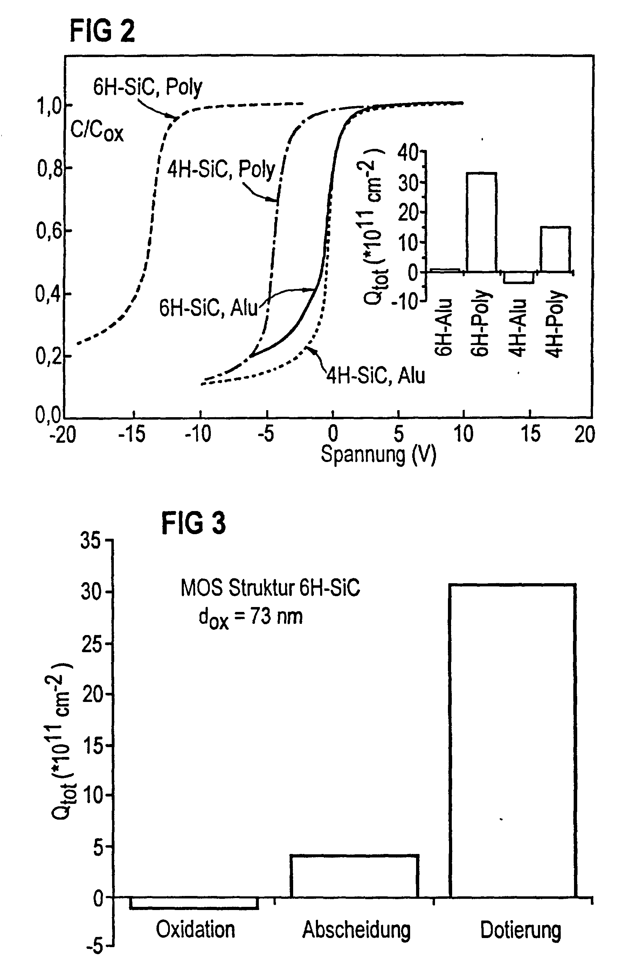

Der aus [1] und [2] bekannte n-Kanal MOSFET besitzt eine ringförmig ausgebildete, etwa 500 nm dicke und durch eine SiO₂-Isolatorschicht vom SiC-Halbleiter getrennte Gate-Elektrode aus polykristallinem Silizium. Bei seiner Herstellung kommen die aus der Si-Technologie stammenden und dort optimierten Verfahren zur Anwendung. So wird das Gatematerial mittels eines CVD-Verfahrens bei einer Temperatur T > 620°C aus der Gasphase abgeschieden und anschließend durch Eindiffundieren von Phosphor in sehr hoher Konzentration ( > 10²¹ cm⁻³ ) dotiert. Der MOSFET leitet bei einer Gatespannung U_{G} = 0 V allerdings bereits Strom ( siehe [1], Fig. 2, S. 2029), wobei sich dieses als normally on" bezeichnete Verhalten nicht auf die unterschiedlich großen Austrittsarbeiten von Gatematerial und Halbleiter zurückführen läßt.

Auch der in [3] beschriebene 6H-SiC MOSFET geht erst dann in den sperrenden Zustand über, wenn die Gateelektrode auf einem negativen Potential liegt. Wie den oben erwähnten Transistor, kann man ihn daher in allen Bereichen der Schalttechnik und Leistungselektronik nicht einsetzen, wo man selbstsperrende ("normally off") MOS-Bauelemente benötigt.

Die Autoren des in [4] veröffentlichten Artikels untersuchten den Einfluß der Prozeßtemperatur auf die Entstehung ortsfester Ladungen während der Herstellung eines Poly-Si/SiO₂/6H-SiC-Bauelements. Sie empfehlen, die Dotierstoffe bei einer Temperatur T ≈ 850 - 900 °C in das Gatematerial einzudiffundieren, um die effektive Dicht ortsfester Ladungen auf Werte Qₜₒₜ < 8-9 • 10 ¹¹ cm⁻² zu begrenzen.

### 3. Gegenstand / Vorteile der Erfindung

Die Erfindung betrifft ein Verfahren gemäß der Ansprüche 1 bis 7 zur Herstellung einer MIS-Struktur (Leiter-Isolator-Halbleiter) auf Siliziumkarbid. Das Verfahren soll gewährleisten, dass an der Grenzfläche Isolator/SiC-Halbleiter deutlich weniger ortsfeste Ladungen entstehen als bei Anwendung konventioneller Fertigungstechniken.

Durch Abscheiden des als Gatematerial dienenden Siliziums in amorpher Form und nachfolgender Dotierung gelingt es, die effektive Dichte der Grenzflächenladungen auf weniger als ein Zehntel des Wertes von entsprechend aufgebauten, allerdings konventionell hergestellten MOSiC-Strukturen zu verringern. Dies ermöglicht beispielsweise die Fertigung von MOSFETs, deren elektrische Eigenschaften nicht oder nur noch unwesentlich von den Grenzflächenladungen beeinflusst werden. So beobachtet man keine Verschiebung ihrer Einsatzspannung zu negativen Werten. Bei einer Gatespannung U_{G} = 0 V, sperren die Transistoren. Sie zeigen damit das insbesondere im Bereich der Schalttechnik und Leistungselektronik geforderte, als "normally off" bezeichnete Verhalten.

### 4. Zeichnungen

Die Erfindung wird im Folgenden anhand der Zeichnungen erläutert. Es zeigen:
- Figur 1: eine MOS-Teststruktur im Querschnitt;
- Figur 2: den Einfluss des Substrat- und Gatematerials auf das Kapazitäts-/Spannungsverhalten von MOS-Teststrukturen;
- Figur 3: Vorzeichen und Betrag der nach Ausführung einzelner Verfahrensschritte zur Herstellung einer MOS-Teststruktur entstehenden Grenzflächenladungen;
- Figur 4: den Einfluss der Dicke des Gateoxids auf die effektive Dichte Qₜₒₜ der Grenzflächenladungen;
- Figur 5: den Einfluß der Abscheidetemperatur auf das Vorzeichen und die effektive Dichte Qₜₒₜ der Grenzflächenladungen;
- Figur 6: das Kapazitäts-/Spannungsverhalten von MOS-Teststrukturen in Abhängigkeit vom Gatematerial und der Art des Herstellungsverfahrens;
- Figur 7: ein SiC-Substrat nach Ausführung einzelner Schritte des erfindungsgemäßen Verfahrens.

### 5. Beschreibung eines Ausführungsbeispiels

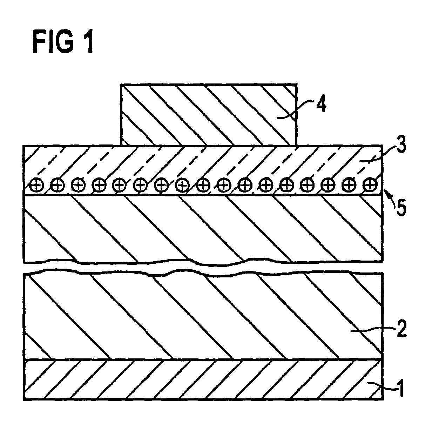

Der in Figur 1 schematisch dargestellte MOS-Kondensator diente als Teststruktur für die im folgenden beschriebenen Messungen. Er bestand im wesentlichen aus dem metallischen Rückseitenkontakt 1, dem n-dotierten SiC-Halbleitersubstrat 2 (4H- oder 6H-Modifikation), der SiO₂-Isolatorschicht 3 und der aus polykristallinem Silizium gefertigten Elektrode 4 (Gate- oder Steuerelektrode). Bei Anwendung der aus der Siliziumtechnologie bekannten Verfahren wurde das Gatematerial bei einer Temperatur T = 620°C und einem Druck p = 250 mTorr aus der Gasphase abgeschieden und anschließend durch Eindiffundieren von Phosphor dotiert (s. [2], Seiten 2171 - 2172). Während dieser Prozeßschritte bildeten sich im Oxid 3 positive Grenzflächenladungen 5, deren effektive Dichte Qₜₒₜ extrem hohe Werte erreichte (s. den rechten Teil der Figur 2). In entsprechend aufgebauten, mit Al-Elektroden ausgestatteten MOS-Teststrukturen wurden demgegenüber wesentlich kleinere Beträge der effektiven Ladungsdichten Qₜₒₜ gemessen. Der linke Teil der Figur 2 zeigt das Kapazitäts-Spannungsverhalten der MOS-Testsrukturen . Dargestellt ist jeweils die normierte Kapazität C/Cₒₓ (Cₒₓ:= Kapazität des Oxids) in Abhängigkeit von der Gatespannung.

Inwieweit die einzelnen Prozeßschritte (Erzeugung des Gateoxids/Abscheiden des polykristallinen Siliziums/Eindiffundieren von Phosphor) zum Aufbau der positiven Grenzflächenladungen beitrugen, kann man Figur 3 entnehmen. Demnach entstanden nur etwa 15% der Ladungen während des Abscheidevorgangs, der weit überwiegende Teil (≈ 85%) während der Dotierung.

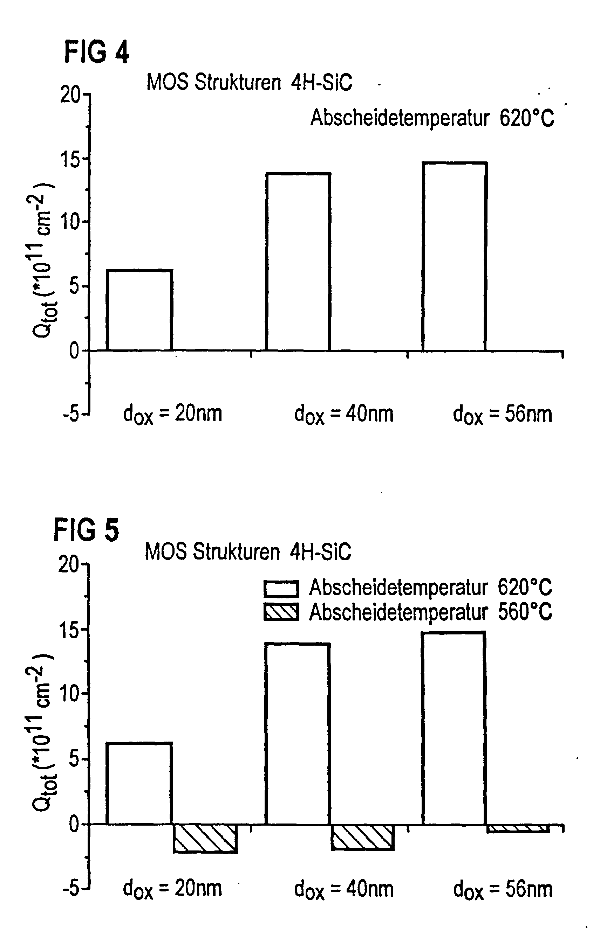

Den Einfluß der Dicke dₒₓ des Gateoxids auf die effektive-Dichte Qₜₒₜ der Grenzflächenladungen zeigt Figur 4. In MOS-Teststrukturen (4H-SiC) mit 40 nm bzw. 56 nm dicken Oxidschichten 3 maß man nahezu dieselbe effektive Dichte Qₜₒₜ an positiven Grenzflächenladungen. Erst eine Reduzierung der Isolatordicke auf etwa 20 nm hatte eine merkliche Verringerung der effektiven Ladungsdichte Qₜₒₜ zur Folge. Diese Meßergebnisse bestätigen die Vermutung, daß nahezu sämtliche Ladungen im Bereich der Grenzfläche Isolator 3/Halbleiter 2 lokalisiert sind.

Wie aus Figur 5 hervorgeht, hat die Abscheidetemperatur für das als Gatematerial dienende Silizium den weitaus größten Einfluß auf die effektive Dichte Qₜₒₜ der Grenzflächenladungen. So entstanden unabhängig von der Dicke dₒₓ des Gateoxids immer negative Grenzflächenladungen mit einer effektiven Dichte Qₜₒₜ < 1-2 x 10¹¹ cm⁻², wenn man die Abscheidetemperatur von T = 620°C auf 450°C ≤ T ≤ 580°C vorzugsweise T = 560°C absenkte und die Dotierung mit Phosphor in bekannter Weise vornahm.

Das Auftreten extrem hoher positiver Ladungsdichten Qₜₒₜ im Gateoxid 3 beruht vermutlich auf der Wirkung mechanischer Spannungen im Gatematerial. Das bei einer Temperatur T = 620°C abgeschiedene Silizium ist polykristallin mit sehr kleinen, säulenförmigen kristallinen Bereichen. Während der Dotierung (Eindiffundieren von Phosphor bei T > 900°C) wachsen die kristallinen Bereiche, wobei die bereits vorhandenen Korngrenzen diesen Vorgang behindern und sich in der MOS-Struktur demzufolge große mechanische Spannungen aufbauen. Besitzt das abgeschiedene Silizium hingegen eine amorphe Struktur (Abscheidetemperatur T < 580°C), kann das Kristallwachstum vergleichsweise unbehindert und mechanisch spannungsfrei erfolgen. In der erfindungsgemäß abgeschiedenen Schicht kommt es so zur Ausbildung vergleichsweise großer kristalliner Bereiche. Zudem ist die Rauhigkeit der Grenzfläche gegenüber den konventionell erzeugten Strukturen deutlich verringert. Wie in MOS-Strukturen auf Si-Substraten beobachtet, wirkt sich dies vorteilhaft auf die für den Transistor relevanten Eigenschaften der MOS-Struktur aus.

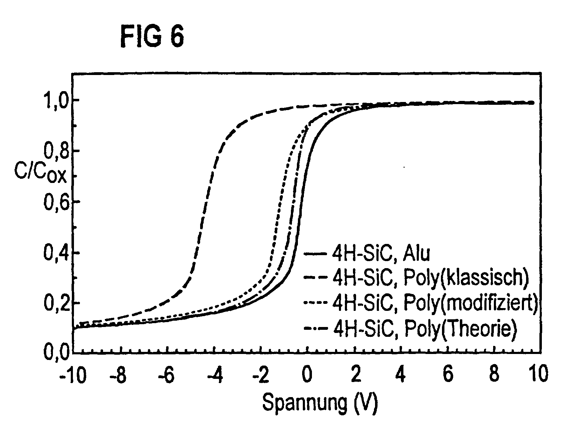

Figur 6 belegt, daß eine erfindungsgemäß hergestellte MOS-Teststruktur annähernd das nach der MOS-Theorie erwartete Kapazitäts-/Spannungsverhalten zeigt. Dargestellt ist wieder die normierte Kapazität C/Cₒₓ in Abhängigkeit von der Gatespannung, wobei die strichpunktiert gezeichnete Kurve den nach der MOS-Theorie erwarteten Verlauf und die punktiert gezeichnete Kurve die an einer erfindungsgemäß hergestellten 4H-MOS-Teststruktur gemessenen Kapazitätsverhältnisse C/Cₒₓ repräsentiert. Ebenfalls dargestellt sind die entsprechenden Meßwerte für eine mit einem Aluminiumgate ausgestattete 4H-MOS-Teststruktur (durchgezogene Kurve) und eine unter Anwendung des bekannten Abscheideverfahrens hergestellte 4H-MOS-Teststruktur mit polykristallinem Silizium als Gatematerial (gestrichelte Kurve).

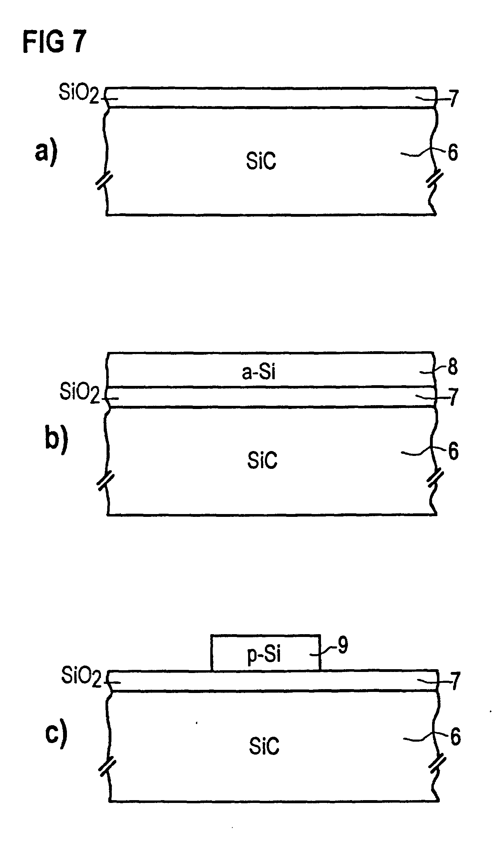

Ausgangspunkt des erfindungsgemäßen Verfahrens zur Herstellung einer MOS-Struktur ist ein mit einer etwa 5 - 500 nm dicken SiO₂-Isolatorschicht 7 versehenes SiC-Substrat 6, auf dessen Oberfläche eine etwa 0,01 - 1 µm dicke Schicht 8 aus amorphem Silizium abgeschieden wird (s. Figur 7a und b). Die Beschichtung erfolgt durch thermische Zersetzung eines beispielsweise Silan (SiH₄) enthaltenden Gasgemischs in der Kammer eines CVD-Reaktors bei einem Druck von beispielsweise p = 250 mTorr und einer Temperatur T < 580°C, vorzugsweise T = 560°C. Anschließend wird das amorphe Silizium mit Phosphor in einer sehr hohen Konzentration (Nₚ > 10²¹ cm⁻³) dotiert, wobei insbesondere die in [2] oder [4] beschriebenen Diffusionsverfahren zur Anwendung kommen können. Da die Temperatur während dieses Prozesses oberhalb von T > 600°C liegt, wandelt sich die Struktur der Siliziumschicht 8 von amorph nach polykristallin um. Der Dotierung folgt die photolithographische Strukturierung der polykristallinen Siliziumschicht 8, um die Gateelektrode 9 zu erzeugen (s. Figur 7c).

### 6. Ausgestaltungen und Weiterbildungen

Die Erfindung beschränkt sich selbstverständlich nicht auf das oben beschriebene Ausführungsbeispiel. So kann man die amorphe Siliziumschicht beispielsweise auch in der Kammer eines Hochfrequenz-Glimmentladungsreaktors mit Hilfe der PECVD (Plasma-Enhanced-Chemical-Vapor-Deposition)-Methode bei einer im Bereich 150°C < T < 300°C liegenden Temperatur auf der beispielsweise aus SiO₂, Al₂O₃ oder Si₃N₄ bestehenden Isolatorschicht 7 des SiC-Substrats 2 (4H-, 6H-Modifikation oder einem anderen Polytyp) abscheiden und anschließend in der oben beschriebenen Weise mit einem als Donator oder Akzeptor wirkenden Element dotieren. Soll die Dotierung während des Aufwachsens der amorphen Si-Schicht 8 erfolgen, wird dem Trägergas das entsprechende Dotiergas (beispielsweise Phosphin PH₃) beigemischt. Da die nachfolgende, der Aktivierung des Dotierstoffes dienende Temperung bei einer Temperatur T > 850°C stattfindet, wird die Siliziumschicht 8 vom amorphen in den polykristallinen Zustand überführt. Kommen andere Dotiertechniken (Ionenimplantation) und Verfahren zur Erzeugung einer ausreichend hohen elektrischen Leitfähigkeit zur Anwendung, bleibt die amorphe Struktur der Si-Schicht 8 gegebenenfalls erhalten.

### 7. Literatur

[1] Appl. Phys. Lett. 51(24), 1987, S. 2028-2030
[2] J. Appl. Phys. 64(4), 1988, S. 2166-2177
[3] Electr. Lett. 31(14), 1995, S. 1200-1201
[4] Appl. Phys. Lett. 68(16), 1996, S. 2231-2233

## Patentansprüche

1. Verfahren zur Herstellung einer MIS-Struktur auf Siliziumkarbid durch Ausführen der folgenden Schritte:
a) Versehen eines aus Siliziumkarbid bestehenden Substrats (6) mit einer aus einem elektrisch isolierenden Material bestehenden ersten Schicht (7);
b) Aufbringen einer amorphen zweiten Schicht (8) auf der ersten Schicht (7), wobei die zweite Schicht (8) aus einem Halbleitermaterial besteht;
c) Ändern der Leitfähigkeit oder des spezifischen Widerstands des Halbleitermaterials der zweiten Schicht (8);
d) Strukturieren der zweiten Schicht (8).

2. Verfahren nach Anspruch 1,
**dadurch gekennzeichnet,**
**daß** die Verfahrensschritte b) und c) gleichzeitig ausgeführt werden.

3. Verfahren nach Anspruch 1 oder 2,
**dadurch gekennzeichnet,**
**daß** die zweite Schicht (8) bei einer Temperatur T < 580°C aufgebracht wird.

4. Verfahren nach Anspruch 1 oder 3,
**dadurch gekennzeichnet,**
**daß** die zweite Schicht (8) bei einer Temperatur T ≥ 850°C in den polykristallinen Zustand überführt und dieser Schritt gleichzeitig mit dem Verfahrensschritt c) oder danach ausgeführt wird.

5. Verfahren nach Anspruch 4,
**dadurch gekennzeichnet,**
**daß** die Leitfähigkeit oder der spezifische Widerstand des Halbleitermaterials durch Einbringen eines als Akzeptor oder Donator wirkenden Elements geändert wird.

6. Verfahren nach einem der Ansprüche 1 bis 5,
**dadurch gekennzeichnet,**
**daß** das Halbleitermaterial aus der Gasphase abgeschieden wird.

7. Verfahren nach einem der Ansprüche 1 bis 6,
**dadurch gekennzeichnet,**
**daß** die zweite Schicht (8) aus Silizium besteht.

## Claims

1. Method for fabricating an MIS structure on silicon carbide by performing the following steps:
a) provision of a substrate (6) comprising silicon carbide with a first layer (7) comprising an electrically insulating material;
b) application of an amorphous second layer (8) on the first layer (7) the second layer (8) comprising a semiconductor material;
c) changing the conductivity or the resistivity of the semiconductor material of the second layer (8);
d) patterning of the second layer (8).

2. Method according to Claim 1,
**characterized in that** method steps b) and c) are performed simultaneously.

3. Method according to Claim 1 or 2,
**characterized**
**in that** the second layer (8) is applied at a temperature T < 580°C.

4. Method according to Claim 1 or 3,
**characterized**
**in that** the second layer (8) is converted into the polycrystalline state at a temperature T ≥ 850°C and this step is performed at the same time as method step c) or afterwards.

5. Method according to Claim 4,
**characterized**
**in that** the conductivity or the resistivity of the semiconductor material is changed by introducing an element acting as an acceptor or donor.

6. Method according to one of Claims 1 to 5,
**characterized**
**in that** the semiconductor material is deposited from the vapour phase.

7. Method according to one of Claims 1 to 6,
**characterized**
**in that** the second layer (8) comprises silicon.

## Revendications

1. Procédé de fabrication d'une structure MIS sur du carbure de silicium par exécution des étapes suivantes :
a) garnir un substrat en carbure de silicium (6) d'une première couche en matériau électriquement isolant (7) ;
b) appliquer une deuxième couche amorphe (8) sur la première couche (7), la deuxième couche (8) se composant d'un matériau semi-conducteur ;
c) changer la conductibilité ou la résistance spécifique de matériau semi-conducteur de la deuxième couche (8) ;
d) structurer la deuxième couche (8).

2. Procédé selon la revendication 1,
**caractérisé en ce que**
les étapes de procédé b) et c) sont réalisées en même temps.

3. Procédé selon la revendication 1 ou 2,
**caractérisé en ce que**
la deuxième couche (8) est appliquée à une température T < 580°C.

4. Procédé selon la revendication 1 ou 3,
**caractérisé en ce que**
la deuxième couche (8) est convertie en l'état polycristallin à une température T ≥ 850°C, et cette étape est réalisée en même temps que l'étape de procédé c) ou après celle-ci.

5. Procédé selon la revendication 4,
**caractérisé en ce que**
la conductibilité ou la résistance spécifique du matériau semi-conducteur est changée par un élément faisant office d'accepteur ou de donneur.

6. Procédé selon l'une quelconque des revendications 1 à 5,
**caractérisé en ce que**
le matériau semi-conducteur est déposé à partir de la phase gazeuse.

7. Procédé selon l'une quelconque des revendications 1 à 6,
**caractérisé en ce que**
la deuxième couche (8) se compose de silicium.
